(19) Europäisches Patentamt
European Patent Office
Office européen des brevets

(11) **EP 4 560 907 A1**

(12) **EUROPEAN PATENT APPLICATION**
published in accordance with Art. 153(4) EPC

(43) Date of publication:
28.05.2025 Bulletin 2025/22

(21) Application number: 23870782.2

(22) Date of filing: 26.09.2023

(51) International Patent Classification (IPC):
*H02M 3/00* (2006.01)

(52) Cooperative Patent Classification (CPC):
G01R 27/08; G01R 27/26; H02M 1/08; H02M 3/00;
H02M 7/04

(86) International application number:
PCT/CN2023/121429

(87) International publication number:
WO 2024/067553 (04.04.2024 Gazette 2024/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 30.09.2022 CN 202211231767

(71) Applicant: Huawei Technologies Co., Ltd.
Shenzhen, Guangdong 518129 (CN)

(72) Inventors:
• LUO, Bin
  Shenzhen, Guangdong 518129 (CN)
• XU, Shui
  Shenzhen, Guangdong 518129 (CN)

(74) Representative: Körber, Martin Hans
Mitscherlich PartmbB
Patent- und Rechtsanwälte
Karlstraße 7
80333 München (DE)

(54) **POWER DISTRIBUTION METHOD AND DEVICE**

(57) This application provides a power distribution method and device, to reduce a power loss of an electrical device. The method includes: A power distribution device receives power distribution parameter information from a first device, where the first device is connected to the power distribution device through a remote cable, and the power distribution device is configured to supply power to the first device; and the power distribution device adjusts an output voltage of the power distribution device based on the power distribution parameter information.

FIG. 4

EP 4 560 907 A1

**Description**

CROSS-REFERENCE TO RELATED APPLICATIONS

This application claims priority to Chinese Patent Application No. 202211231767.6, filed with the China National Intellectual Property Administration on September 30, 2022 and entitled "POWER DISTRIBUTION METHOD AND DEVICE", which is incorporated herein by reference in its entirety.

TECHNICAL FIELD

Embodiments of this application relate to the field of communication technologies, and in particular, to a power distribution method and device.

BACKGROUND

A power module deployed on a base station device can convert an external alternating current into a direct current and supply power to a radio frequency module of the base station through a remote cable. The remote cable has a resistance. Therefore, when the radio frequency module operates, an operating current passes through the remote cable, causing a power loss.

How to reduce the power loss caused by the remote cable is a problem worth studying.

SUMMARY

Embodiments of this application provide a power distribution method and device, to reduce a power loss caused by a remote cable.

According to a first aspect, an embodiment of this application provides a power distribution method, applied to a power distribution device. The power distribution device is configured to supply power to a first device. The method includes: The power distribution device receives power distribution parameter information from a first device, and the power distribution device adjusts an output voltage of the power distribution device based on the power distribution parameter information.

In the foregoing design, the power distribution device supplies power to the first device based on a power distribution requirement of the first device. This design is flexible, and can meet an operating power required by the first device. The power distribution device has a voltage boost function. The foregoing design may be applied to a scenario in which a power loss exists on a line between the power distribution device and the first device. For example, the first device is connected to the power distribution device through a remote cable. A voltage boost power distribution manner determined based on the power distribution requirement of the first device can reduce a power loss caused by the remote cable, reduce a waste of electric energy, and improve power distribution performance.

In a possible design, the power distribution parameter information includes one or more of the following: a first input voltage of the first device, an input capacitance of the first device, a power of the first device, and a maximum input voltage that the first device is able to bear.

The following describes solutions for adjusting the output voltage of the power distribution device in different cases.

In a first possible design, when the first input voltage of the first device is less than the maximum input voltage, the power distribution device may increase the output voltage of the power distribution device.

In a range allowed by the maximum input voltage, increasing the output voltage of the power distribution device may increase an input voltage of the first device, to decrease an operating current of the first device. When the power distribution device and the first device are connected through the remote cable, a power loss of the remote cable can be reduced by reducing the operating current.

In a second possible design, when a difference between a current of the remote cable and a maximum current threshold is less than a current threshold, the output voltage of the power distribution device is decreased.

The maximum current threshold may be an operating current during a sudden power drop of the first device. This design can prevent the input voltage of the first device from overshooting and exceeding the maximum input voltage due to the sudden power drop of the first device. The voltage boost power distribution manner can reduce a loss of the remote cable and also ensure normal running of the first device.

Optionally, the maximum current threshold is determined based on the input capacitance of the first device, a resistance of the remote cable, and an inductance of the remote cable; or the maximum current threshold is preconfigured.

Optionally, the power distribution device may further detect the output voltage of the power distribution device and the current of the remote cable, to obtain a detection result; and determine the resistance of the remote cable and the inductance of the remote cable based on the detection result.

In a third possible design, the output voltage of the power distribution device is greater than an input voltage of the power distribution device. When the power of the first device is less than a power threshold, the power distribution device may adjust the output voltage of the power distribution device. An adjusted output voltage of the power distribution device is equal to the input voltage of the power distribution device. This design may be applied to a scenario in which the power of the first device is low, and a power loss of the remote cable does not affect normal operation of the first device. The output voltage of the power distribution device is adjusted to be equal to the input voltage, so that the power distribution device enters a sleep state, to reduce a power loss of the power distribution device and improve power distribution performance.

Based on the foregoing design, the adjusted output voltage of the power distribution device is used to determine a second input voltage of the first device. The second input voltage of the first device is less than the maximum input voltage, and a difference between the second input voltage of the first device and the maximum input voltage is greater than or equal to a voltage threshold. The voltage threshold is related to the inductance of the remote cable and the input capacitance of the first device. In this design, the input voltage of the first device or an overshoot value of the input voltage of the first device does not exceed the maximum input voltage, and normal running of the first device can be ensured.

In a possible design, the input voltage of the power distribution device is determined based on an output voltage of a power module connected to the power distribution device, and the output voltage of the power distribution device is greater than the output voltage of the power module. Optionally, the power module may be an AC-DC power supply.

According to a second aspect, an embodiment of this application provides a power distribution device. The power distribution device is configured to supply power to a first device, and the power distribution device includes a communication circuit, a control circuit, and an adjustment circuit. The communication circuit is configured to receive power distribution parameter information from the first device. The control circuit is configured to control, based on the power distribution parameter information, the adjustment circuit to adjust an output voltage of the power distribution device.

In a possible design, the communication circuit and the control circuit are connected to the first device through a remote cable.

In a possible design, the power distribution parameter information includes one or more of the following: a first input voltage of the first device, an input capacitance of the first device, a power of the first device, and a maximum input voltage that the first device is able to bear.

In a possible design, the control circuit is specifically configured to: when a first input voltage of the first device is less than the maximum input voltage, control the adjustment circuit to increase the output voltage of the power distribution device.

In a possible design, the control circuit is specifically configured to: when a difference between a current of the remote cable and a maximum current threshold is less than a current threshold, control the adjustment circuit to decrease the output voltage of the power distribution device.

In a possible design, the maximum current threshold is determined by the control circuit based on the input capacitance of the first device, a resistance of the remote cable, and an inductance of the remote cable; or the maximum current threshold is preconfigured.

In a possible design, the power distribution device further includes a detection circuit. The detection circuit is configured to detect the output voltage of the power distribution device and the current of the remote cable, to obtain a detection result. The control circuit is further configured to determine the resistance of the remote cable and the inductance of the remote cable based on the detection result.

In a possible design, the output voltage of the power distribution device is greater than an input voltage of the power distribution device. The control circuit is specifically configured to: when the power of the first device is less than a power threshold, control the adjustment circuit to adjust the output voltage of the power distribution device. An adjusted output voltage of the power distribution device is equal to the input voltage of the power distribution device.

In a possible design, the adjusted output voltage of the power distribution device is used to determine a second input voltage of the first device. The second input voltage of the first device is less than the maximum input voltage, and a difference between the second input voltage of the first device and the maximum input voltage is greater than or equal to a voltage threshold. The voltage threshold is related to the inductance of the remote cable and the input capacitance of the first device.

In a possible design, the input voltage of the power distribution device is determined based on an output voltage of a power module connected to the power distribution device, and the output voltage of the power distribution device is greater than the output voltage of the power module.

According to a third aspect, an embodiment of this application provides a power distribution device. The power distribution device is configured to supply power to a first device, and the power distribution device includes a communication module, a control module, and an adjustment module. The communication module is configured to receive power distribution parameter information from the first device. The control module is configured to control, based on the power distribution parameter information, the adjustment module to adjust an output voltage of the power distribution device.

In a possible design, the communication module and the control module are connected to the first device through a remote cable.

In a possible design, the power distribution parameter information includes one or more of the following: a first input voltage of the first device, an input capacitance of the first device, a power of the first device, and a maximum input voltage that the first device is able to bear.

In a possible design, the control module is specifically configured to: when a first input voltage of the first device is less than the maximum input voltage, control the adjustment module to increase the output voltage of the power distribution device.

In a possible design, the control module is specifically configured to: when a difference between a current of the remote cable and a maximum current threshold is less than a current threshold, control the adjustment module to decrease the output voltage of the power distribution device.

In a possible design, the maximum current threshold is determined by the control module based on the input capacitance of the first device, a resistance of the remote cable, and an inductance of the remote cable; or the maximum current threshold is preconfigured.

In a possible design, the power distribution device further includes a detection module. The detection module is configured to detect the output voltage of the power distribution device and the current of the remote cable, to obtain a detection result. The control module is further configured to determine the resistance of the remote cable and the inductance of the remote cable based on the detection result.

In a possible design, the output voltage of the power distribution device is greater than an input voltage of the power distribution device. The control module is specifically configured to: when the power of the first device is less than a power threshold, control the adjustment module to adjust the output voltage of the power distribution device. An adjusted output voltage of the power distribution device is equal to the input voltage of the power distribution device.

In a possible design, the adjusted output voltage of the power distribution device is used to determine a second input voltage of the first device. The second input voltage of the first device is less than the maximum input voltage, and a difference between the second input voltage of the first device and the maximum input voltage is greater than or equal to a voltage threshold. The voltage threshold is related to the inductance of the remote cable and the input capacitance of the first device.

In a possible design, the input voltage of the power distribution device is determined based on an output voltage of a power module connected to the power distribution device, and the output voltage of the power distribution device is greater than the output voltage of the power module.

According to a fourth aspect, an embodiment of this application provides a power distribution system, including the power distribution device described in the second aspect or the third aspect and a first device. Optionally, the power distribution system further includes a power module connected to the power distribution device.

According to a fifth aspect, an embodiment of this application further provides a computer program. When the computer program is run on a computer, the computer is enabled to perform the method according to the first aspect.

According to a sixth aspect, an embodiment of this application further provides a computer program product, including instructions. When the instructions are run on a computer, the computer is enabled to perform the method according to any one of the first aspect and the possible designs of the first aspect.

According to a seventh aspect, an embodiment of this application further provides a computer-readable storage medium. The computer-readable storage medium stores a computer program or instructions. When the computer program or the instructions are run on a computer, the computer is enabled to perform the method according to any one of the first aspect and the possible designs of the first aspect.

According to an eighth aspect, an embodiment of this application further provides a chip. The chip is configured to perform the method according to any one of the first aspect and the possible designs of the first aspect. Optionally, the chip is configured to read a computer program stored in a memory, to perform the method according to any one of the first aspect and the possible designs of the first aspect.

According to a ninth aspect, an embodiment of this application further provides a chip system. The chip system includes a processor, configured to support a computer apparatus in implementing the method according to any one of the first aspect and the possible designs of the first aspect. In a possible design, the chip system further includes a memory, and the memory is configured to store a program and data that are necessary for the computer apparatus. The chip system may include a chip, or may include a chip and another discrete device.

For effects of the solutions provided in any one of the second aspect to the ninth aspect, refer to the corresponding descriptions in the first aspect.

BRIEF DESCRIPTION OF DRAWINGS

FIG. 1 is a diagram of a structure of a communication system;

FIG. 2 is a schematic of power supply based on an AC/DC power supply;

FIG. 3 is a diagram of a power distribution architecture according to an embodiment of this application;

FIG. 4 is a schematic flowchart of a power distribution method according to an embodiment of this application;

FIG. 5A is a schematic of an oscillation circuit;

FIG. 5B is a diagram of a current change curve;

FIG. 6 is a diagram of a structure of a power distribution device according to an embodiment of this application;

FIG. 7 is a diagram of a structure of a power distribution device according to an embodiment of this application;

FIG. 8 is a diagram of a structure of a power distribution device according to an embodiment of this application; and

FIG. 9 is a diagram of a structure of a power distribution device according to an embodiment of this application.

## DESCRIPTION OF EMBODIMENTS

To make objectives, technical solutions, and advantages of embodiments of this application clearer, the following further describes embodiments of this application in detail with reference to the accompanying drawings.

At least one (item) in embodiments of this application indicates one or more (items). A plurality of (items) indicates two (items) or more than two (items). The term "and/or" describes an association relationship for describing associated objects and represents that three relationships may exist. For example, A and/or B may represent the following three cases: Only A exists, both A and B exist, and only B exists. The character "/" generally indicates an "or" relationship between the associated objects. In addition, it should be understood that although terms such as "first" and "second" may be used in embodiments of this application to describe objects, these objects should not be limited by these terms. These terms are merely used to distinguish the objects from each other.

The terms "include", "have", and any variants thereof in the following descriptions of embodiments of this application are intended to cover a non-exclusive inclusion. For example, a process, a method, a system, a product, or a device that includes a series of steps or units is not limited to the listed steps or units, but optionally further includes other unlisted steps or units, or optionally further includes another inherent step or unit of the process, the method, the product, or the device. It should be noted that, in embodiments of this application, the word "example" or "for example" is used to represent giving an example, an illustration, or a description. Any method or design solution described as an "example" or "for example" in embodiments of this application should not be explained as being more preferred or having more advantages than another method or design solution. To be precise, use of the words such as "example" and "for example" is intended to present a relative concept in a specific manner.

Technologies provided in embodiments of this application are applicable to various communication systems. For example, the communication system may be a 3rd generation (3rd generation, 3G) communication system (for example, a universal mobile telecommunication system (universal mobile telecommunication system, UMTS)), a 4th generation (4th generation, 4G) communication system (for example, a long term evolution (long term evolution, LTE) system), a 5th generation (5th generation, 5G) communication system, a worldwide interoperability for microwave access (worldwide interoperability for microwave access, WiMAX) or wireless local area network (wireless local area network, WLAN) system, a system integrating a plurality of systems, or a future communication system, for example, a 6th generation (6th generation, 6G) communication system. The 5G communication system may also be referred to as a new radio (new radio, NR) system.

A network element in the communication system may send a signal to another network element or receive a signal from another network element. The signal may include information, data, or the like. The network element may also be referred to as an entity, a network entity, a device, a communication device, a communication module, a node, a communication node, or the like. In embodiments of this application, the network element is used as an example for description. For example, the communication system may include at least one terminal device and at least one network device. A signal sending network element may be a network device, and a signal receiving network element may be a terminal device; or a signal sending network element may be a terminal device, and a signal receiving network element may be a network device. In addition, it may be understood that if the communication system includes a plurality of terminal devices, the plurality of terminal devices may further send signals to each other. That is, both a signal sending network element and a signal receiving network element may be terminal devices.

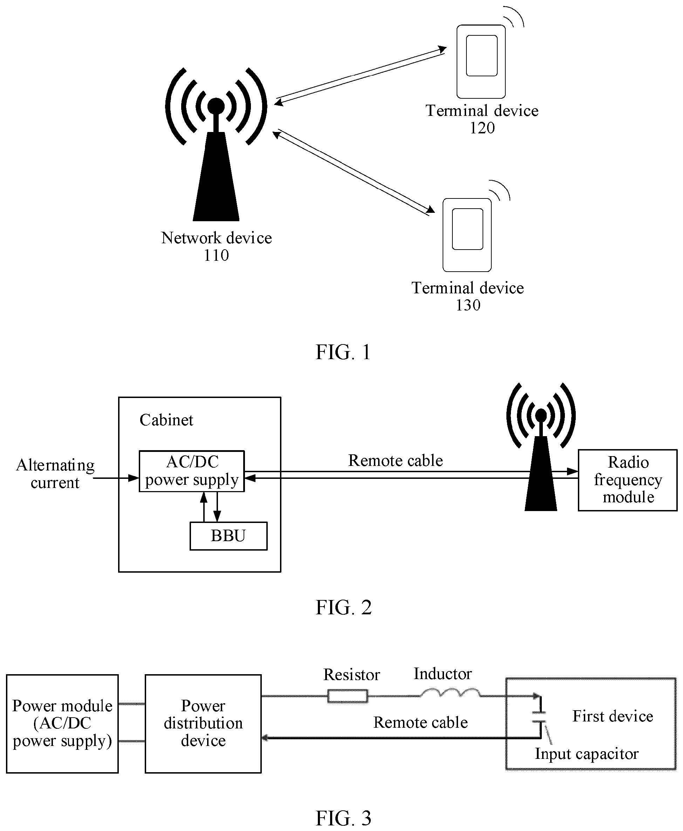

FIG. 1 shows a communication system. For example, the communication system includes a network device 110 and two terminal devices: a terminal device 120 and a terminal device 130. At least one of the terminal device 120 and the terminal device 130 may send uplink data to the network device 110, and the network device 110 may receive the uplink data. The network device may send downlink data to at least one of the terminal device 120 and the terminal device 130.

The following describes in detail the terminal device and the network device in FIG. 1.

(1) Terminal device

The terminal device is also referred to as a terminal, user equipment (user equipment, UE), a mobile station (mobile station, MS), a mobile terminal (mobile terminal, MT), or the like, and is a device that provides a user with voice and/or data connectivity. The terminal device may communicate with one or more core network devices through the network device. The terminal device includes a handheld device having a wireless connection function, another processing device connected to a wireless modem, a vehicle-mounted device, or the like. The terminal device may be a portable, pocket-sized, handheld, computer built-in, or vehicle-mounted mobile apparatus. Examples of some terminal devices are: a personal communication service (personal communication service, PCS) phone, a cordless phone, a session initiation protocol (session initiation protocol, SIP) phone, a wireless local loop (wireless local loop, WLL) station, a personal digital assistant (personal digital assistant, PDA), a wireless network camera, a mobile phone (mobile phone), a tablet computer, a notebook computer, a palmtop computer, a mobile internet device (mobile internet device, MID), a wearable device such as a smartwatch, a virtual reality (virtual reality, VR) device, an augmented reality (augmented reality, AR) device, a wireless terminal in industrial control (industrial control), a terminal in an internet of vehicles system, a wireless terminal in self driving (self driving), a wireless terminal in a smart grid (smart grid), a wireless terminal in transportation safety (transportation safety), a wireless terminal such as a smart fueler in a smart city (smart city), a terminal device on a high-speed railway, and a wireless terminal in a smart home (smart home), such as a smart speaker, a smart coffee machine, and a smart printer.

In embodiments of this application, a communication apparatus configured to implement a function of the terminal device may be a terminal device, or may be a terminal device having a part of a function of a terminal, or may be an apparatus that can support the terminal device in implementing the function, for example, a chip system. The apparatus may be installed in the terminal device. In embodiments of this application, the chip system may include a chip, or may include a chip and another discrete device. In the technical solutions provided in embodiments of this application, an example in which the communication apparatus configured to implement a function of the terminal device is the terminal device or UE is used for description.

(2) Network device

The network device may be a base station (base station, BS), or the network device may be referred to as an access network device, an access node (access node, AN), or a radio access node (radio access node, RAN). The network device may be connected to a core network (for example, an LTE core network or a 5G core network), and the network device may provide a wireless access service for a terminal device. Some examples of the network device include but are not limited to at least one of the following: a next-generation NodeB (generation node B, gNB) in 5G, a network device in an open radio access network (open radio access network, O-RAN), an evolved NodeB (evolved node B, eNB), a radio network controller (radio network controller, RNC), a NodeB (node B, NB), a base station controller (base station controller, BSC), a base transceiver station (base transceiver station, BTS), a home base station (for example, a home evolved nodeB, a home nodeB, HNB), a transmitting and receiving point (transmitting and receiving point, TRP), a transmitting point (transmitting point, TP), and/or a mobile switching center. Alternatively, the network device may be a relay station, an access point, a vehicle-mounted device, a wearable device, a network device in a future evolved public land mobile network (public land mobile network, PLMN), or the like.

The network device may include a baseband unit (base band unit, BBU) and a radio frequency device (or referred to as a radio frequency unit). When the network device sends information to the terminal device, the BBU generates a baseband signal that represents the information, and sends the baseband signal to the radio frequency device. The radio frequency device performs intermediate radio frequency processing on the baseband signal to obtain a radio frequency signal, sends the radio frequency signal to an antenna system, and sends the radio frequency signal to the terminal device through the antenna system. Optionally, the radio frequency device may also have some baseband functions. That is, some baseband functions close to the radio frequency may be moved to the radio frequency device for implementation. For example, the radio frequency device may implement at least one of the following: fast Fourier transform (fast fourier transform, FFT) transform/inverse fast Fourier transform (inverse fast fourier transformation, iFFT), beamforming, and extraction and filtering of a physical random access channel (physical random access channel, PRACH). For example, an interface between the BBU and the radio frequency device may be a common public radio interface (common public radio interface, CPRI) interface, an enhanced common public radio interface (enhanced common public radio interface, eCPRI) interface, or a fronthaul interface between a distribution unit (distributed unit, DU) and a radio unit (radio unit, RU) in an O-RAN system, or the like. This is not limited. The baseband signal is an original electrical signal that is sent by a transmitting end such as the network device and that is not modulated (for example, spectrum migration and conversion). The baseband signal may be classified into a digital baseband signal and an analog baseband signal based on a feature of the original electrical signal. The radio frequency device may be a remote radio unit (remote radio unit, RRU), an active antenna unit (active antenna unit, AAU), or another unit, module, or device having a radio frequency processing function. The antenna system may include a transmit antenna and a receive antenna.

Optionally, a function of the BBU in this application may be implemented by a general-purpose device such as a general-purpose computer or server. In other words, the BBU described in this application may be replaced with another possible device, and the device may implement the function of the BBU in this application.

A BBU and a radio frequency device of a network device may be integrated into one cabinet, and the radio frequency device is connected to an antenna system through a feeder. Alternatively, the BBU and the radio frequency device may be separated. For example, the BBU is installed in a cabinet, and the radio frequency device and the antenna system are disposed on a base station tower. The BBU and the radio frequency device are connected through an optical cable (optical cable), and the radio frequency device and the antenna system are connected through a jumper (jumper). The network device in which the BBU and the radio frequency device are separated may also be described as a distributed network device or a distributed base station. One BBU may support connection to a plurality of radio frequency devices, and one network device may include one BBU and one or more radio frequency devices.

In embodiments of this application, a communication apparatus configured to implement the function of the BBU may be a BBU, or may be a device having a part of the function of the BBU, or may be an apparatus that can support the BBU in implementing the function, for example, a chip system, a hardware circuit, a software module, or a hardware circuit and a software module. The apparatus may be installed in the BBU. In the method in embodiments of this application, an example in which the communication apparatus configured to implement the function of the BBU is a BBU is used for description.

In embodiments of this application, a communication apparatus configured to implement a function of the radio frequency device may be a radio frequency device, or may be a device having a part of the function of the radio frequency device, or may be an apparatus that can support the radio frequency device in implementing the function, for example, a chip system, a hardware circuit, a software module, or a hardware circuit and a software module. The apparatus may be installed in the radio frequency device. In the method in embodiments of this application, an example in which the communication apparatus configured to implement the function of the radio frequency device is a radio frequency device is used for description.

Embodiments of this application mainly relate to a power supply technology in a scenario in which a BBU and a radio frequency device are separated. Refer to FIG. 2. Devices such as a BBU and a radio frequency device in a network device are powered by a power module. The BBU and the power module are deployed in a cabinet (for example, a power supply cabinet), and the radio frequency module is deployed on a base station tower of the network device or at another separated location. Both the power module and the BBU are connected to the radio frequency module through remote cables. The power module converts an external input alternating current (alternative current, AC) into a direct current (direct current, DC), to provide the direct current for the BBU and the radio frequency module. Alternatively, the power module outputs a direct current voltage to the BBU and the radio frequency module. The power module may also be referred to as an alternating current-to-direct current (AC/DC) power supply. In addition, optionally, a fan may be further deployed in the cabinet. It may be understood that the power module is further configured to supply power to the fan.

The remote cable has a resistance. Therefore, when the radio frequency module operates, an operating current passes through the remote cable, causing a power loss. An input voltage of the radio frequency module is less than an output voltage of the power module. A voltage boost circuit is introduced between the power module and the radio frequency module to increase the input voltage of the radio frequency module. An output of the AC/DC power supply is connected to an input of the voltage boost circuit, and an output of the voltage boost circuit is connected to the radio frequency module through the remote cable. For example, an input of the AC/DC power supply is connected to an external alternating current power supply (for example, a mains supply), and an output voltage of a direct current of the AC/DC power supply is 53 volts (V). The voltage boost circuit may increase 53 V to output a 63 V power distribution voltage.

When a power of the radio frequency module remains unchanged, if the input voltage of the radio frequency module is increased, the operating current of the radio frequency module is decreased. It can be learned from the following formula (1) and formula (2) that when the operating current passing through the remote cable is decreased, a voltage and a power of the remote cable are decreased. That is, the power loss caused by the remote cable decreases.

$$\Delta V = I * R \qquad\qquad (1)$$

$$P_l = \Delta V * I \qquad\qquad (2)$$

$\Delta V$ represents the voltage of the remote cable; or $\Delta V$ may be described as a voltage drop, and is a difference between an output voltage of the voltage boost circuit and the input voltage of the radio frequency module. I represents the operating current of the radio frequency module. $P_l$ represents the power loss of the remote cable. R represents the resistance of the remote cable.

For example, Table 1 shows that when the power of the radio frequency module is 1200 and related parameters (for example, a cable diameter and a remote distance) of the remote cable are the same, 53.5 V and 63 V are used as power distribution voltages to supply power to the radio frequency module. A current of the remote cable corresponding to 53.5 V is greater than a current of the remote cable corresponding to 63 V, and a power loss of the remote cable corresponding to 53.5 V is greater than a power loss of the remote cable corresponding to 63 V.

Table 1

| Power distribution voltage (V) | Power (W) of the radio frequency module | Cable diameter (mm$^2$) | Remote distance (m) | Current (A) of the remote cable | Power loss (W) of the remote cable |
|---|---|---|---|---|---|
| 53.5 | 1200 | 6 | 70 | 30 | 404.2 |
| 63 | 1200 | 6 | 70 | 22.7 | 232.4 |

In an implementation, the voltage boost circuit stably outputs a fixed voltage, for example, boosts a voltage from 53.5 V to 63 V for output. Although such a design can reduce the power loss of the remote cable, flexibility is poor, and electric energy may be wasted. Even, for example, in a specific scenario in which the power of the radio frequency module is small, a power loss of the introduced voltage boost circuit may be greater than the power loss of the remote cable. Consequently, a power loss is increased for an entire power distribution circuit of the radio frequency module.

Based on this, embodiments of this application provide a power distribution method, to supply power to a first device based on a power distribution requirement of the first device. This is flexible. The first device may also be replaced with an electrical device. The first device may be the radio frequency module in the foregoing network device; or the first device may be a device such as a server in a data network center.

The power distribution method may be performed by a power distribution device having a voltage boost function, and the power distribution device is configured to supply power to the first device. The power distribution method may be applied to a scenario in which a power loss exists on a line between the power distribution device and the first device. For example, the power distribution device is connected to the first device through a cable, a remote cable, or another circuit structure, and a power loss is caused because the cable, the remote cable, or another manner has a resistance. This is not limited in embodiments of this application.

FIG. 3 shows that the power distribution device may communicate with the first device to obtain a power consumption requirement of the first device, and supply power to the first device through the remote cable. The remote cable has a resistance value and an inductance value. FIG. 3 uses a resistance and an inductance as an example. However, it should be understood that the resistance shown in FIG. 3 is an equivalent resistance on the remote cable. One or more resistor components may be actually deployed on the remote cable. The inductance shown in FIG. 3 is an equivalent inductance formed due to a characteristic of the remote cable, for example, a conductive performance. An actual inductor component may be deployed on the remote cable, or an actual inductor component may not be deployed on the remote cable. This is not limited in embodiments of this application. In addition, FIG. 3 further shows an input capacitor deployed in the first device. The power distribution device, the remote cable, and the first device form a circuit loop, or referred to as a closed loop.

Optionally, FIG. 3 further shows that the power distribution device is connected to a power module (that is, an AC-DC power supply), and an input voltage of the power distribution device is determined based on an output voltage of the power module. When the power distribution device operates, the power distribution device has a voltage boost function. An output voltage of the power distribution device is greater than the input voltage of the power distribution device, and the output voltage of the power distribution device is greater than the output voltage of the power module.

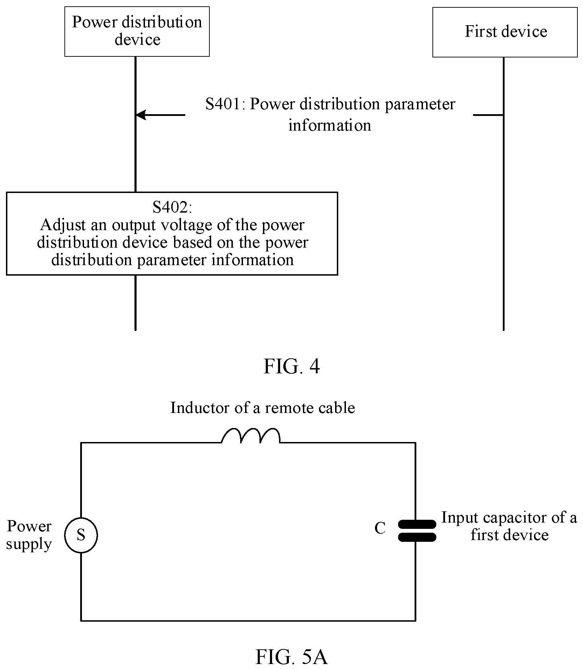

Based on FIG. 3, FIG. 4 shows a power distribution method. The power distribution method mainly includes the following procedure.

S401: A first device sends power distribution parameter information to a power distribution device, and correspondingly, the power distribution device receives the power distribution parameter information from the first device.

The power distribution parameter information indicates a power consumption requirement of the first device. For example, the power distribution parameter information includes one or more of the following: a first input voltage of the first device, an input capacitance of the first device, a power of the first device, and a maximum input voltage that the first device is able to bear. It may be understood that the first input voltage, the input capacitance, and the power of the first device are obtained by the first device through detection or estimation, and are not limited. The first input voltage of the first device is an input voltage when the first device sends the power distribution parameter information. For example, FIG. 3 shows the input capacitor deployed in the first device. The input voltage of the first device may also be understood as a voltage of the input capacitor of the first device. In this case, the first input voltage is a voltage of the input capacitor of the first device when the first device sends the power distribution parameter information. The power of the first device is an operating power of the first device. For example, the first device is a radio frequency module, and a power of the radio frequency module is divided into a transmit power for sending a radio frequency signal by the radio frequency module and a receive power for receiving a radio frequency signal. The maximum voltage that the first device is able to bear may be preconfigured. For example, the maximum voltage that the first device is able to bear is a rated voltage of the first device, or the maximum voltage that the first device is able to bear is higher than the rated voltage of the first device.

S402: The power distribution device adjusts an output voltage of the power distribution device based on the power distribution parameter information.

In a first optional implementation, the power distribution parameter information includes the first input voltage of the first device and the maximum input voltage that the first device is able to bear. When the first input voltage of the first device is less than the maximum input voltage, the power distribution device may increase the output voltage of the power distribution device. This design can reduce a power loss of a remote cable.

During specific implementation, when increasing the output voltage of the power distribution device, the power distribution device should consider the maximum input voltage that the first device is able to bear. That is, the power distribution device may detect a resistance value on the remote cable, and determine an increment of the output voltage of the power distribution device based on the maximum input voltage that the first device is able to bear and the resistance value on the remote cable. In this manner, it can be ensured that the input voltage of the first device is less than the maximum input voltage.

For example, the first device is a radio frequency module. As shown in Table 2, before S402, the output voltage (that is, a power distribution voltage) of the power distribution device is 63 V. After S402, the output voltage of the power distribution device is increased to 69 V, and a power loss on the remote cable is reduced.

Table 2

| Power distribution voltage (V) | Power (W) of the radio frequency module | Cable diameter (mm$^2$) | Remote distance (m) | Current (A) of the remote cable | Input voltage (V) of the first device | Power loss (W) of the remote cable |
|---|---|---|---|---|---|---|
| 63 | 1200 | 6 | 70 | 22.7 | 52.8 | 232.4 |
| 69 | 1200 | 6 | 70 | 20 | 60 | 179.7 |

In a second optional implementation, when the power of the first device suddenly drops, an operating current of the first device also suddenly drops, and this causes oscillation between an inductor of the remote cable and the input capacitor of the first device, to form an LC oscillation circuit. The LC oscillation circuit is a circuit including an inductor (represented by a letter L) and a capacitor (represented by a letter C), and the LC oscillation circuit may also be referred to as an oscillation circuit for short. For example, on the basis of FIG. 3, FIG. 5A shows an LC oscillation circuit. The LC oscillation circuit includes the inductor of the remote cable and the input capacitor of the first device, and the inductor of the remote cable and the input capacitor of the first device are connected in series. With reference to FIG. 3, it may be understood that the power distribution device supplies power to the oscillation circuit.

When the power of the first device suddenly drops, energy stored on the inductor of the remote cable included in the LC oscillation circuit is transferred to the input capacitor of the first device. This causes a voltage overshoot of the input capacitor of the first device, that is, causes an overshoot of the input voltage of the first device. It may be understood that when the power of the first device suddenly drops, the operating current of the first device also suddenly drops. In this case, a voltage and the power loss of the remote cable may be ignored. For example, when the first device is a radio frequency module, when the radio frequency module suddenly drops from a transmit power 1200 W to a receive power 200 W, an operating current of the radio frequency module suddenly drops, and an LC oscillation circuit is formed, resulting in an overshoot of an input voltage of the radio frequency module. For example, when a power distribution voltage (for example, the output voltage of the power distribution device) is 53.5 V, the input voltage of the radio frequency module may overshoot to 55.1 V when the power of the radio frequency module suddenly drops. When the power distribution voltage (for example, the output voltage of the power distribution device) is 63 V, the input voltage of the radio frequency module may overshoot to 64.3 V when the power of the radio frequency module suddenly drops.

It can be learned from the foregoing content that, when the power of the first device suddenly drops from a high level to a low level, an overshoot value of the input voltage of the first device may exceed the maximum input voltage that the first device is able to bear. The overshoot value of the input voltage of the first device may also be replaced with a voltage stress of the first device. To avoid this case, in an optional design, a maximum power threshold that can be reached by the first device may be limited, that is, a maximum current threshold that can be reached by the first device is limited, to prevent a sudden power drop of the first device. For example, the power distribution device may adjust the output voltage of the power distribution device in the following manner: When determining that a difference between the current of the remote cable and the maximum current threshold is less than a current threshold, the power distribution device may decrease the output voltage of the power distribution device.

The current threshold may also be preconfigured or determined by the power distribution device. With regard to a definition of the maximum current threshold, it may be understood that when the current of the remote cable reaches the maximum current threshold, a sudden power drop may occur, and consequently, the input voltage of the first device exceeds the maximum input voltage, and normal running of the first device is affected. Optionally, for a manner of determining the maximum current threshold, refer to the following two manners for understanding.

Manner 1: The maximum current threshold may be preconfigured, for example, is an empirical value.

Manner 2: The maximum current threshold may alternatively be determined by the power distribution device based on the power distribution parameter information from the first device. For example, the power distribution parameter information sent by the first device may include the first input voltage of the first device, the input capacitance of the first device, and the maximum input voltage that the first device is able to bear. The power distribution device may determine a resistance and an inductance of the remote cable based on the power distribution parameter information. Further, the power distribution device determines the maximum current threshold based on the input capacitance of the first device, the resistance of the remote cable, and the inductance of the remote cable.

For example, the power distribution device may detect a current output voltage of the power distribution device and the current of the remote cable, and determine the resistance of the remote cable according to Formula (3).

$$R = \frac{(Vs - Vr)}{I} \qquad (3)$$

R represents the resistance of the remote cable, I represents the current of the remote cable, that is, the operating current of the first device, Vs represents the current output voltage of the power distribution device, and Vr represents the first input voltage of the first device.

For example, the power distribution device may detect the current output voltage of the power distribution device and the current of the remote cable, and determine the inductance of the remote cable according to Formula (4).

$$T = 2\pi * \sqrt{L * C} \qquad (4)$$

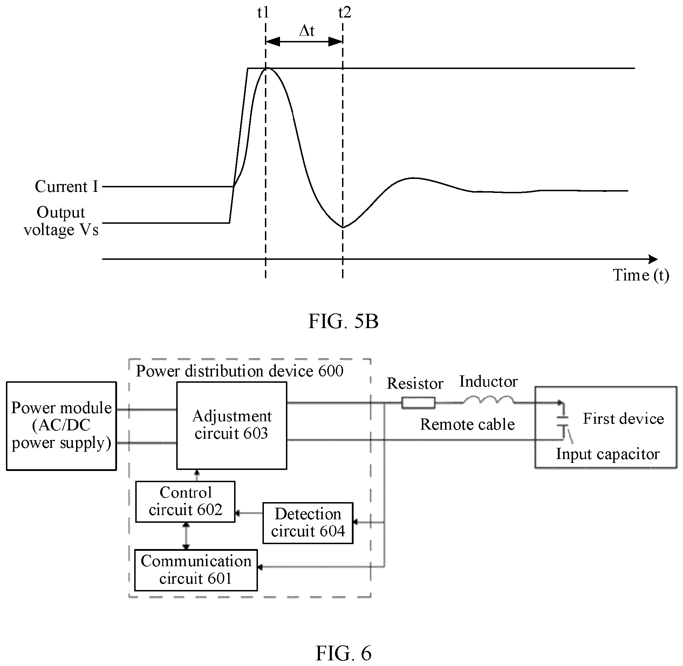

T represents an oscillation periodicity, and the power distribution device may determine a value of T by detecting the current of the remote cable. As shown in FIG. 5B, the power distribution device may adjust the output voltage Vs of the power distribution device, detect the current I of the remote cable in real time in a preset time period, and may determine a peak value (that is, a largest value) of I and a valley value (that is, a smallest value) of I in the time period. Further, the power distribution device may determine a difference $\Delta t$ between a moment t1 corresponding to the peak value of I and a moment t2 corresponding to the valley value of I. T is twice of $\Delta t$, or $\Delta t$ is a half of T.

L represents the inductance of the remote cable, and C represents the input capacitance of the first device. Optionally, the value C in Formula (4) is indicated by the first device to the power distribution device by using the power distribution parameter information. Alternatively, the value C in Formula (4) may change with time, and an initial value of C is indicated by the first device to the power distribution device by using the power distribution parameter information. The power distribution device substitutes the initial value of C into Formula (4) to obtain a value of L. Subsequently, the power distribution device re-detects the current of the remote cable at a specified interval to determine new T, and then the power distribution device substitutes new T and the value of L into Formula (4) to derive changed C.

For example, the power distribution device may determine the maximum current threshold according to the following formula (5):

$$\frac{1}{2} * L * I_p{}^2 = \frac{1}{2} * C * V_m{}^2 - \frac{1}{2} * C * (V_s - I * R)^2 \qquad (5)$$

$I_p$ represents the maximum current threshold, and $V_m$ represents the maximum input voltage that the first device is able to bear. For definitions of L, C, $V_s$, I, and R, refer to the descriptions in the foregoing example for understanding. Details are not described in this embodiment of this application.

In the foregoing implementation, an overshoot state of an output voltage of the first device is analyzed, and the maximum current threshold is set, so that the output voltage of the first device does not exceed the maximum output voltage, and normal running of the first device can be ensured.

In a third optional implementation, the first device may indicate the power of the first device to the power distribution device by using the power distribution parameter information. That is, the power distribution parameter information may include the power of the first device. When the power of the first device is less than a power threshold, the power distribution device may determine that there is no need to supply power to the first device through voltage boosting. In this case, for a voltage boost function, the power distribution device may not work, and enter a sleep state. For example, when the power of the first device is less than the power threshold, the power distribution device adjusts the output voltage of the power distribution device, so that the power distribution device enters a sleep state. An adjusted output voltage of the power distribution device is equal to an input voltage of the power distribution device. Optionally, when the power distribution device is connected to a power module, it may be understood that after the power distribution device enters a sleep state, the power module supplies power to the first device through the remote cable, and an output voltage of the power module is used to determine the input voltage of the first device.

When the first device is in a low power state, the first device does not need to use a voltage boost power distribution manner, and the output voltage of the power distribution device is adjusted to hibernate the power distribution device, so that a waste of electric energy can be reduced.

According to the foregoing embodiment, it may be understood that the adjusted output voltage of the power distribution device is used to determine a second input voltage of the first device. The second input voltage of the first device is less than the maximum input voltage, and a difference between the second input voltage of the first device and the maximum input voltage is greater than or equal to a voltage threshold. The voltage threshold is set, so that an overshoot value of the input voltage of the first device does not exceed the maximum input voltage. The voltage threshold may be preconfigured. For example, the voltage threshold is an empirical value. Alternatively, the voltage threshold is related to the inductance of the remote cable and the input capacitance of the first device. For example, the inductor of the remote cable and the input capacitor of the first device are connected in series to form an oscillation circuit. The power distribution device may determine a difference between a voltage of the input capacitor of the first device in the oscillation circuit and an output voltage of the power distribution device during a sudden power drop of the first device as the voltage threshold. Optionally, the power distribution device may estimate, by simulation, the difference between the voltage of the input capacitor of the first device in the oscillation circuit and the output voltage of the power distribution device during the sudden power drop of the first device. Alternatively, the first device may indicate, to the power distribution device, the voltage of the input capacitor of the first device in the oscillation circuit during the sudden power drop of the first device, so that the power distribution device obtains the foregoing difference through calculation.

In this embodiment of this application, the power distribution device that can communicate with the first device performs voltage boost power distribution, so that the output voltage of the power distribution device can be flexibly adjusted to adapt to a power consumption requirement of the first device, and a waste of electric energy is reduced while a power loss of a cable is reduced, to improve power distribution performance.

According to the foregoing method embodiment, an embodiment of this application provides a power distribution device 600. Refer to FIG. 6. The power distribution device 600 includes a communication circuit 601, a control circuit 602, and an adjustment circuit 603. The communication circuit 601 and the control circuit 602 are connected to a first device through a remote cable, and the power distribution device is configured to supply power to the first device.

The communication circuit 601 is configured to receive power distribution parameter information from the first device.

For a definition of the power distribution parameter information, refer to the descriptions in S401 for understanding. Details are not described in this embodiment of this application.

The control circuit 602 is configured to control, based on the power distribution parameter information, the adjustment circuit 603 to adjust an output voltage of the power distribution device.

Specifically, the control circuit 602 mainly controls the adjustment circuit 603 to implement the optional implementations described in S402. Details are not described in this embodiment of this application.

In addition, the power distribution device 600 may further include a detection circuit 604. The detection circuit 604 is mainly configured to: detect the output voltage of the power distribution device and a current of the remote cable, to obtain a detection result; and send the detection result to the control circuit 602. For example, the control circuit 602 may determine a resistance of the remote cable and an inductance of the remote cable based on the detection result.

The following describes internal structures of the communication circuit 601, the control circuit 602, the adjustment circuit 603, and the detection circuit 604 by using examples.

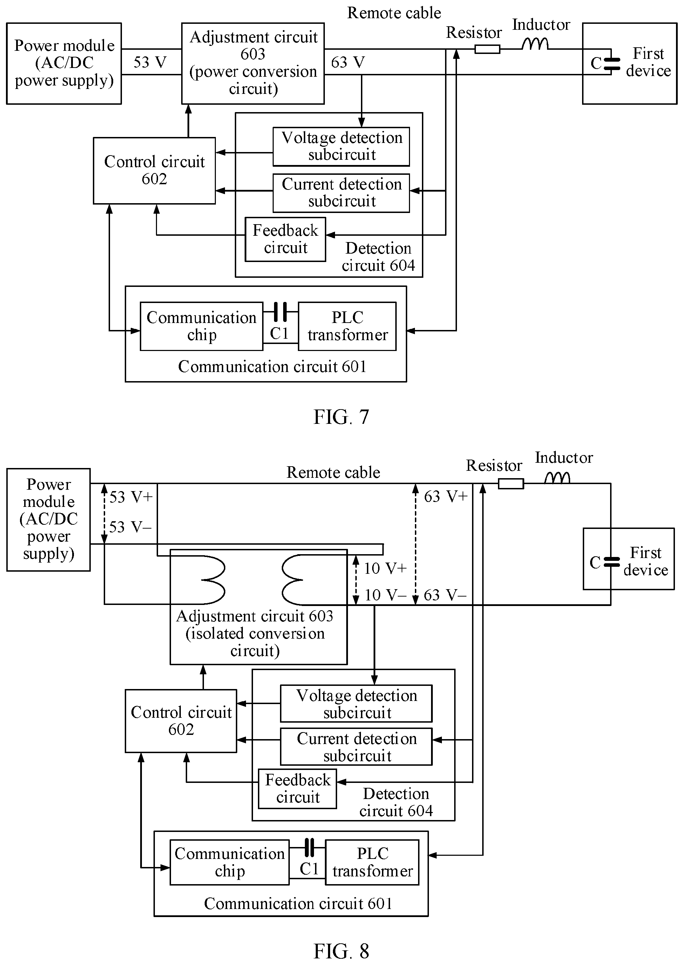

Example 1: Based on FIG. 6, FIG. 7 further shows internal structures of the communication circuit 601, the control circuit 602, the adjustment circuit 603, and the detection circuit 604. For example, the communication circuit 601 is mainly implemented by using a power line carrier communication (power line communication, PLC) communication circuit, and the communication circuit 601 includes a communication chip, a capacitor C1, and a PLC transformer. The control circuit 602 may be implemented by using a chip or a circuit that has a processing and analysis function. For example, the control circuit 602 may be a microcontroller unit (microcontroller unit, MCU) with a pulse width modulation (pulse width modulation, PWM) function, or another processor. The adjustment circuit 603 may be implemented by a power conversion circuit. The control circuit 602 controls an output voltage of the power conversion circuit by adjusting a duty cycle of PWM. The output voltage of the power conversion circuit is the output voltage of the power distribution device, and the output voltage of the power distribution device is greater than an output voltage of a power module. The detection circuit 604 may specifically include a voltage detection subcircuit and a current detection subcircuit. The voltage detection subcircuit sends a detected output voltage of the power distribution device to the control circuit for overvoltage protection. The current detection subcircuit sends a detected current on the remote cable to the control circuit for overcurrent protection. Optionally, the detection circuit 604 may further include a feedback circuit configured to sample the output voltage of the power distribution device. For example, the feedback circuit may periodically detect the output voltage of the power distribution device and feed back the output voltage to the control circuit according to a configuration. The control circuit may control, based on the voltage periodically fed back by the feedback circuit, the output voltage of the power distribution device to stabilize at a preset target value. For example, FIG. 7 shows that the output voltage $V_0$ of the power module is 53 V, and after voltage boosting by the power distribution device, the output voltage $V_s$ of the power distribution device is 63 V.

Example 2: Based on FIG. 6, FIG. 8 further shows internal structures of the communication circuit 601, the control circuit 602, the adjustment circuit 603, and the detection circuit 604. For understanding of the communication circuit 601, the control circuit 602, and the detection circuit 604, refer to the descriptions in Example 1. Details are not described in this embodiment of this application. A difference between FIG. 8 and FIG. 7 lies in the adjustment circuit 603. FIG. 8 shows a manner in which the adjustment circuit 603 is implemented by using an isolated conversion circuit. The control circuit controls an output voltage of the isolated conversion circuit by adjusting a duty cycle of PWM. The output voltage of the power distribution device is a sum of the output voltage of the isolated conversion circuit and an input voltage of the power distribution device. For example, FIG. 8 shows that an output voltage $V_0$ of a power module is 53 V, and the power distribution device is connected to the power module. For example, the isolated conversion circuit is connected to the power module. The input voltage of the power distribution device is $V_0$ (53 V), an input voltage of the isolated conversion circuit is $V_0$ (53 V) and the output voltage of the isolated conversion circuit is $V_i$ (10 V). The output voltage $V_s$ of the power distribution device is $V_0+V_i$, that is, 63 V.

Based on a same technical conception, an embodiment of this application further provides a power distribution device 900. For example, the power distribution device 900 may be a chip or a chip system. Optionally, in this embodiment of this application, the chip system may include a chip, or may include a chip and another discrete device.

The power distribution device 900 may include at least one processor 910. Optionally, the processor 910 is coupled to a memory. The memory may be located in the apparatus. Alternatively, the memory may be integrated with the processor. Alternatively, the memory may be located outside the apparatus. For example, the power distribution device 900 may further include at least one memory 920. The memory 920 stores a computer program, a computer program or instructions, and/or data necessary for implementing any one of the foregoing examples. The processor 910 may execute the computer program stored in the memory 920, to complete the method in any one of the foregoing examples.

The power distribution device 900 may further include a communication interface 930, and the power distribution device 900 may exchange information with a first device through the communication interface 930. For example, the communication interface 930 may be a transceiver, a circuit, a bus, a module, a pin, or a communication interface of another type. When the power distribution device 900 is a chip-type apparatus or circuit, the communication interface 930 in the apparatus 900 may alternatively be an input/output circuit, and may input information (or receive information) and output information (or send information). The processor is an integrated processor, a microprocessor, an integrated circuit, or a logic circuit, and the processor may determine output information based on input information.

The coupling in this embodiment of this application may be an indirect coupling or a communication connection between apparatuses, units, or modules in an electrical form, a mechanical form, or another form, and is used for information exchange between the apparatuses, the units, or the modules. The processor 910 may operate in collaboration with the memory 920 and the communication interface 930. A specific connection medium between the processor 910, the memory 920, and the communication interface 930 is not limited in embodiments of this application.

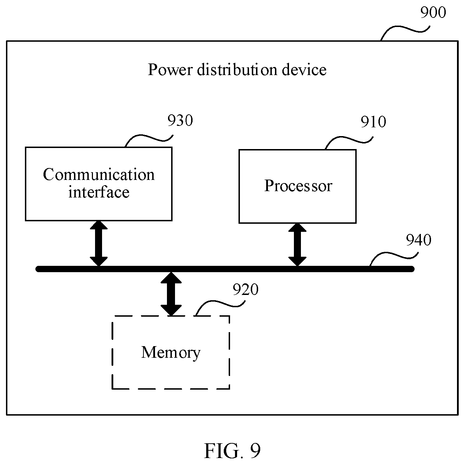

Optionally, refer to FIG. 9. The processor 910, the memory 920, and the communication interface 930 are connected to each other through a bus 940. The bus 940 may be a peripheral component interconnect (peripheral component interconnect, PCI) bus, an extended industry standard architecture (extended industry standard architecture, EISA) bus, or the like. The bus may be classified into an address bus, a data bus, a control bus, and the like. For ease of representation, only one thick line is used to represent the bus in FIG. 9, but this does not mean that there is only one bus or only one type of bus.

In embodiments of this application, the processor may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in embodiments of this application. The general-purpose processor may be a microprocessor or any conventional processor or the like. The steps of the method disclosed with reference to embodiments of this application may be directly performed by a hardware processor, or may be performed by using a combination of hardware in the processor and a software module.

In embodiments of this application, the memory may be a non-volatile memory, such as a hard disk drive (hard disk drive, HDD) or a solid-state drive (solid-state drive, SSD), or may be a volatile memory (volatile memory), such as a random access memory (random access memory, RAM). The memory is any other medium that can be used to carry or store expected program code in a form of instructions or a data structure and that can be accessed by a computer, but is not limited thereto. The memory in embodiments of this application may alternatively be a circuit or any other apparatus that can implement a storage function, and is configured to store the program instructions and/or the data.

Based on the foregoing example, an embodiment of this application further provides a power distribution system,

**EP 4 560 907 A1**

including a power distribution device and a first device. The power distribution device and the first device may implement the power distribution method provided in the example shown in FIG. 4. Optionally, the power distribution system may further include a power module (for example, an AC-DC power supply) that provides an input voltage for the power distribution device.

The technical solutions provided in embodiments of this application may be fully or partially implemented through software, hardware, firmware, or any combination thereof. When software is used to implement the embodiments, all or a part of the embodiments may be implemented in a form of a computer program product. The computer program product includes one or more computer instructions. When the computer program instructions are loaded and executed on the computer, the procedures or functions according to embodiments of this application are all or partially generated. The computer may be a general-purpose computer, a special-purpose computer, a computer network, a network management device, a PMU, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk drive, or a magnetic tape), an optical medium (for example, a digital video disc (digital video disc, DVD)), a semiconductor medium, or the like.

In embodiments of this application, on the premise that there is no logical conflict, examples may be mutually referenced. For example, methods and/or terms in the method embodiments may be mutually referenced. For example, functions and/or terms in the apparatus embodiments may be mutually referenced. For example, functions and/or terms in the apparatus examples and the method examples may be mutually referenced.

Apparently, a person skilled in the art may make various modifications and variations to embodiments of this application without departing from the scope of embodiments of this application. In this way, embodiments of this application are also intended to cover these modifications and variations provided that they fall within the scope of the claims of embodiments of this application and equivalent technologies thereof.

**Claims**

1. A power distribution method, applied to a power distribution device, and comprising:

   receiving power distribution parameter information from a first device, wherein the first device is connected to the power distribution device through a remote cable, and the power distribution device is configured to supply power to the first device; and
   adjusting an output voltage of the power distribution device based on the power distribution parameter information.

2. The power distribution method according to claim 1, wherein the power distribution parameter information comprises one or more of the following: a first input voltage of the first device, an input capacitance of the first device, a power of the first device, and a maximum input voltage that the first device is able to bear.

3. The power distribution method according to claim 2, wherein the adjusting an output voltage of the power distribution device based on the power distribution parameter information comprises:
   when the first input voltage of the first device is less than the maximum input voltage, increasing the output voltage of the power distribution device.

4. The power distribution method according to claim 2, wherein the adjusting an output voltage of the power distribution device based on the power distribution parameter information comprises:
   when a difference between a current of the remote cable and a maximum current threshold is less than a current threshold, decreasing the output voltage of the power distribution device, wherein the maximum current threshold is determined based on the input capacitance of the first device, a resistance of the remote cable, and an inductance of the remote cable.

5. The power distribution method according to claim 4, wherein the power distribution method further comprises:

   detecting the output voltage of the power distribution device and the current of the remote cable, to obtain a detection result; and
determining the resistance of the remote cable and the inductance of the remote cable based on the detection result.

6. The power distribution method according to claim 2, wherein the output voltage of the power distribution device is greater than an input voltage of the power distribution device, and the adjusting an output voltage of the power distribution device based on the power distribution parameter information comprises:
when the power of the first device is less than a power threshold, adjusting the output voltage of the power distribution device, wherein an adjusted output voltage of the power distribution device is equal to the input voltage of the power distribution device.

7. The power distribution method according to any one of claims 2 to 6, wherein the adjusted output voltage of the power distribution device is used to determine a second input voltage of the first device, the second input voltage of the first device is less than the maximum input voltage, a difference between the second input voltage of the first device and the maximum input voltage is greater than or equal to a voltage threshold, and the voltage threshold is related to the inductance of the remote cable and the input capacitance of the first device.

8. The power distribution method according to any one of claims 1 to 7, wherein the input voltage of the power distribution device is determined based on an output voltage of a power module connected to the power distribution device, and the output voltage of the power distribution device is greater than the output voltage of the power module.

9. A power distribution device, comprising a communication circuit, a control circuit, and an adjustment circuit, wherein the communication circuit and the control circuit are connected to a first device through a remote cable, and the power distribution device is configured to supply power to the first device;

the communication circuit is configured to receive power distribution parameter information from the first device; and
the control circuit is configured to control, based on the power distribution parameter information, the adjustment circuit to adjust an output voltage of the power distribution device.

10. The power distribution device according to claim 9, wherein the power distribution parameter information comprises one or more of the following: a first input voltage of the first device, an input capacitance of the first device, a power of the first device, and a maximum input voltage that the first device is able to bear.

11. The power distribution device according to claim 10, wherein the control circuit is specifically configured to:
when a first input voltage of the first device is less than the maximum input voltage, control the adjustment circuit to increase the output voltage of the power distribution device.

12. The power distribution device according to claim 10, wherein the control circuit is specifically configured to:
when a difference between a current of the remote cable and a maximum current threshold is less than a current threshold, control the adjustment circuit to decrease the output voltage of the power distribution device, wherein the maximum current threshold is determined based on the input capacitance of the first device, a resistance of the remote cable, and an inductance of the remote cable.

13. The power distribution device according to claim 12, further comprising a detection circuit, wherein

the detection circuit is configured to detect the output voltage of the power distribution device and the current of the remote cable, to obtain a detection result; and
the control circuit is further configured to determine the resistance of the remote cable and the inductance of the remote cable based on the detection result.

14. The power distribution device according to claim 10, wherein the output voltage of the power distribution device is greater than an input voltage of the power distribution device, and the control circuit is specifically configured to:
when the power of the first device is less than a power threshold, control the adjustment circuit to adjust the output voltage of the power distribution device, wherein an adjusted output voltage of the power distribution device is equal to the input voltage of the power distribution device.

15. The power distribution device according to any one of claims 10 to 14, wherein the adjusted output voltage of the power distribution device is used to determine a second input voltage of the first device, the second input voltage of the first device is less than the maximum input voltage, a difference between the second input voltage of the first device and the maximum input voltage is greater than or equal to a voltage threshold, and the voltage threshold is related to the inductance of the remote cable and the input capacitance of the first device.

16. The power distribution device according to any one of claims 9 to 15, wherein the input voltage of the power distribution device is determined based on an output voltage of a power module connected to the power distribution device, and the output voltage of the power distribution device is greater than the output voltage of the power module.

17. A power distribution device, wherein the power distribution device is configured to supply power to a first device, and the power distribution device comprises a communication module, a control module, and an adjustment module;

    the communication module is configured to receive power distribution parameter information from the first device; and

    the control module is configured to control, based on the power distribution parameter information, the adjustment module to adjust an output voltage of the power distribution device.

18. A communication system, comprising the power distribution device and the first device according to any one of claims 9 to 17.

19. A chip, wherein the chip is configured to read a computer program stored in a memory, to perform the method according to any one of claims 1 to 8.

20. A computer program, comprising instructions, wherein when the instructions are run on a computer, the computer is enabled to perform the method according to any one of claims 1 to 8.

21. A computer-readable storage medium, wherein the computer-readable storage medium stores a computer program or instructions, and when the computer program or the instructions are run on a computer, the computer is enabled to perform the method according to any one of claims 1 to 8.

FIG. 1

FIG. 2

FIG. 3

**EP 4 560 907 A1**

```
┌─────────────────┐                              ┌─────────────────┐
│ Power distribution│                             │   First device  │
│      device      │                              │                 │
└─────────────────┘                              └─────────────────┘
         │                                                │
         │◄──── S401: Power distribution parameter ───────│
         │              information                       │
         │                                                │
┌─────────────────────────────────────────┐               │
│               S402:                      │               │
│   Adjust an output voltage of the power  │               │
│  distribution device based on the power  │               │
│    distribution parameter information    │               │
└─────────────────────────────────────────┘               │
         │                                                │
```

FIG. 4

Inductor of a remote cable

Power supply (S)  C  Input capacitor of a first device

FIG. 5A

17

t1    t2

Δt

Current I

Output
voltage Vs

Time (t)

FIG. 5B

Power distribution device 600

Power module
(AC/DC
power supply)

Adjustment
circuit 603

Resistor   Inductor

Remote cable

First device

Input capacitor

Control
circuit 602

Detection
circuit 604

Communication
circuit 601

FIG. 6

Remote cable

| Power module (AC/DC power supply) | 53 V | Adjustment circuit 603 (power conversion circuit) | 63 V | Resistor | Inductor | First device |

Voltage detection subcircuit

Current detection subcircuit

Control circuit 602

Feedback circuit

Detection circuit 604

Communication chip · C1 · PLC transformer

Communication circuit 601

FIG. 7

Remote cable

Resistor  Inductor

Power module (AC/DC power supply)  53 V+  53 V−  63 V+  63 V−

10 V+  10 V−

First device

Adjustment circuit 603 (isolated conversion circuit)

Voltage detection subcircuit

Current detection subcircuit

Control circuit 602

Feedback circuit

Detection circuit 604

Communication chip · C1 · PLC transformer

Communication circuit 601

FIG. 8

900

Power distribution device

930

910

Communication interface

Processor

940

920

Memory

FIG. 9

**EP 4 560 907 A1**

## INTERNATIONAL SEARCH REPORT

International application No.

**PCT/CN2023/121429**

### A. CLASSIFICATION OF SUBJECT MATTER

H02M3/00(2006.01)i

According to International Patent Classification (IPC) or to both national classification and IPC

### B. FIELDS SEARCHED

Minimum documentation searched (classification system followed by classification symbols)

IPC:H02M; H02J

Documentation searched other than minimum documentation to the extent that such documents are included in the fields searched

Electronic data base consulted during the international search (name of data base and, where practicable, search terms used)

CNABS; CNTXT; VEN; USTXT; EPTXT; WOTXT; DWPI; CNKI; IEEE: 射频, 配电, 供电, 拉远, 调节, 调整, 改变, 电压, 电流, 电阻, 电感, 电容器, 振荡, 谐振, radio frequency, power distribution, power supply, remote, regulate, adjust, change, voltage, current, resistance, inductance, capacitor, oscillation, resonance

### C. DOCUMENTS CONSIDERED TO BE RELEVANT

| Category* | Citation of document, with indication, where appropriate, of the relevant passages | Relevant to claim No. |
|---|---|---|
| X | CN 113923062 A (ZTE CORP.) 11 January 2022 (2022-01-11) description, paragraphs 24-119, and figures 1-11 | 1-21 |
| X | CN 107181252 A (HUAWEI TECHNOLOGIES CO., LTD.) 19 September 2017 (2017-09-19) description, paragraphs 50-105, and figures 1-9 | 1-21 |
| A | CN 102439835 A (HUAWEI TECHNOLOGIES CO., LTD.) 02 May 2012 (2012-05-02) entire document | 1-21 |
| A | CN 1855827 A (HUAWEI TECHNOLOGIES CO., LTD.) 01 November 2006 (2006-11-01) entire document | 1-21 |
| A | US 2007064922 A1 (SCHINDLER FREDERICK R) 22 March 2007 (2007-03-22) entire document | 1-21 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **22 December 2023** | **29 December 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/121429**

| Patent document cited in search report | | | Publication date (day/month/year) | Patent family member(s) | | | Publication date (day/month/year) |
|---|---|---|---|---|---|---|---|
| CN | 113923062 | A | 11 January 2022 | WO | 2022007868 | A1 | 13 January 2022 |
| | | | | JP | 2023534209 | W | 08 August 2023 |
| CN | 107181252 | A | 19 September 2017 | WO | 2017152631 | A1 | 14 September 2017 |
| CN | 102439835 | A | 02 May 2012 | WO | 2012083746 | A1 | 28 June 2012 |
| CN | 1855827 | A | 01 November 2006 | CN | 100544263 | C | 23 September 2009 |
| US | 2007064922 | A1 | 22 March 2007 | US | 7451329 | B2 | 11 November 2008 |

Form PCT/ISA/210 (patent family annex) (July 2022)

**REFERENCES CITED IN THE DESCRIPTION**

**Patent documents cited in the description**

- CN 202211231767